(19) Europäisches Patentamt
European Patent Office
Office européen des brevets

(11) **EP 4 607 792 A1**

(12) **DEMANDE DE BREVET EUROPEEN**

(43) Date de publication:
**27.08.2025 Bulletin 2025/35**

(21) Numéro de dépôt: **25156421.7**

(22) Date de dépôt: **07.02.2025**

(51) Classification Internationale des Brevets (IPC):
**H03B 5/04** *(2006.01)*     **G05F 3/30** *(2006.01)*
**H03B 5/12** *(2006.01)*     **H03J 3/20** *(2006.01)*
**H03L 1/02** *(2006.01)*     **G05F 3/20** *(2006.01)*

(52) Classification Coopérative des Brevets (CPC):
**H03B 5/124; G05F 3/30; H03B 5/04**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **20.02.2024 FR 2401637**

(71) Demandeur: **STMicroelectronics International N.V.**
**1228 Plan-les-Ouates, Geneva (CH)**

(72) Inventeurs:
• **TOUZARD, Olivier**
**38100 GRENOBLE (FR)**
• **ANDRE, Eric**
**38570 HURTIERES (FR)**

(74) Mandataire: **Cabinet Beaumont**
**4, Place Robert Schuman**
**B.P. 1529**
**38025 Grenoble Cedex 1 (FR)**

(54) **DISPOSITIF DE POLARISATION D'UNE CAPACITE VARIABLE**

(57) La présente description concerne un dispositif (500). Un premier circuit (BG) fournit un premier courant (Ibg) circulant dans premier élément résistif recevant une tension stable en température, et un deuxième courant (Iptat) proportionnel à la température. Un deuxième élément résistif (R) comprend des transistors MOS (T) en série et en diode, et a une première borne connectée à un potentiel de référence (GND) et une deuxième borne couplée à un potentiel d'alimentation (VDD). Un deuxième circuit (C1) fournit, dans le deuxième élément résistif (R), une copie (Ibgc1) du premier courant (Ibg). Un troisième circuit (C2) applique une tension à une grille arrière (600) des transistors (T), déterminée par le deuxième courant (Iptat).

**Fig. 5**

## Description

### Domaine technique

La présente description concerne de façon générale les circuits électroniques, et, plus particulièrement les circuits électroniques comprenant une capacité variable.

### Technique antérieure

De nombreux circuits électroniques comprennent une capacité variable, c'est à dire un composant capacitif ayant une valeur de capacité réglable. A titre d'exemple, les oscillateurs contrôlés en tension ("Voltage Controlled Oscillator") sont des circuits électroniques comprenant une capacité variable.

Les circuits électroniques comprenant une capacité variable présentent divers inconvénients. Par exemple, leur fonctionnement peut dépendre de la température en plus de la valeur de leur capacité variable, ce qui pose problème. C'est par exemple le cas dans les oscillateurs contrôlés en tension comprenant une capacité variable, par exemple les oscillateurs contrôlés en tension configurés pour fournir un signal radiofréquence ayant, par exemple, une fréquence supérieure à 1 GHz, voire supérieure à 10 GHz, par exemple environ égale à 20 GHz.

### Résumé de l'invention

Il existe un besoin de pallier tout ou partie des inconvénients des circuits électroniques comprenant une capacité variable.

Par exemple, il existe un besoin pour un dispositif fournissant une tension à une capacité variable d'un circuit électronique qui permette de compenser au moins en partie l'effet de la température sur un paramètre de fonctionnement du circuit électronique.

Par exemple, il existe un besoin pour un dispositif permettant de fournir une tension à une capacité variable d'un oscillateur contrôlé en tension qui permette de compenser au moins en partie l'effet de la température sur la fréquence de l'oscillateur, par exemple lorsque la fréquence de l'oscillateur est asservie par une boucle à verrouillage de phase (PLL de l'anglais "Phase Locked Loop").

Un mode de réalisation pallie tout ou partie des inconvénients des circuits électroniques connus comprenant une capacité variable.

Par exemple, un mode de réalisation pallie tout ou partie des inconvénients des dispositifs connus fournissant une tension à une capacité variable d'un circuit électronique.

Par exemple, un mode de réalisation pallie tout ou partie des inconvénients des dispositifs connus fournissant une tension à une capacité variable d'un oscillateur contrôlé en tension, par exemple un oscillateur contrôlé en tension et asservi par une boucle à verrouillage de phase.

Un mode de réalisation prévoit un dispositif comprenant :

un premier circuit à bande interdite configuré pour appliquer une tension stable en température aux bornes d'un premier élément résistif de sorte qu'un premier courant y circule, et

pour fournir un deuxième courant proportionnel à la température absolue ;
un deuxième élément résistif comprenant un ou plusieurs transistors MOS en série et montés chacun en diode, le deuxième élément résistif ayant une première borne connectée à un noeud d'application d'un potentiel de référence et une deuxième borne couplée à un noeud d'application d'un potentiel d'alimentation ;
un deuxième circuit connecté au premier circuit et configuré pour fournir une première copie du premier courant et que ladite première copie circule dans le deuxième élément résistif, le deuxième élément résistif (R) faisant partie du deuxième circuit (C1) ; et
un troisième circuit connecté au premier circuit et configuré pour :

- fournir une copie du deuxième courant, fournir une première tension de commande à partir de ladite copie du deuxième courant, et appliquer la première tension de commande à une grille arrière des transistors de l'élément résistif, ou
- fournir une deuxième copie du premier courant et une copie du deuxième courant, fournir une première tension de commande à partir d'une différence entre la deuxième copie du deuxième courant et la copie du premier courant, et appliquer la première tension de commande à une grille arrière des transistors du deuxième élément résistif.

Selon un mode de réalisation, la deuxième borne du deuxième élément résistif est configurée pour fournir une tension de polarisation à une capacité variable.

Selon un mode de réalisation, le dispositif comprend la capacité variable, la capacité variable est configurée pour recevoir une tension de réglage et la tension de polarisation, et une différence entre la tension de réglage et la tension de polarisation détermine une valeur de la capacité.

Selon un mode de réalisation, le deuxième élément résistif est en série avec une résistance, la deuxième borne du deuxième élément résistif est configurée pour fournir une première tension de polarisation à une capacité variable et est connectée à une première borne de ladite résistance, et une deuxième borne de ladite résistance est configurée pour fournir une deuxième tension de polarisation à la capacité variable.

Selon un mode de réalisation, le dispositif comprend la capacité variable, la capacité variable est configurée pour recevoir une tension de réglage et les première et deuxième tensions de polarisation, et une différence entre la tension de réglage et la première tension de polarisation et une différence entre la tension de réglage et la deuxième tension de polarisation déterminent une valeur de la capacité.

Selon un mode de réalisation, le dispositif comprend un oscillateur commandé en tension comprenant la capacité variable.

Selon un mode de réalisation, le dispositif comprend un circuit de fourniture de la tension de réglage, ledit circuit comprenant, par exemple, une boucle à verrouillage de phase.

Selon un mode de réalisation, le troisième circuit comprend une résistance ayant une première borne connectée au noeud d'application du potentiel de référence ou au noeud d'application du potentiel d'alimentation, une deuxième borne de ladite résistance étant configurée pour fournir la première tension de commande et étant connectée à la grille arrière des transistors du deuxième élément résistif.

Selon un mode de réalisation, le troisième circuit comprend une capacité de lissage connecté entre la grille arrière des transistors du deuxième élément résistif et le noeud d'application du potentiel de référence.

Selon un mode de réalisation, les transistors du deuxième élément résistif sont tous des transistors à canal N ou sont tous des transistors MOS à canal P.

Selon un mode de réalisation, les transistors du deuxième élément résistif sont tous mis en oeuvre sur silicium sur isolant.

Selon un mode de réalisation, le troisième circuit comprend un circuit de réglage d'une pente de la première tension de commande avec la température.

Selon un mode de réalisation, le circuit de réglage comprend un ou plusieurs ensembles comprenant chacun :

- une première résistance et un premier interrupteur en série entre le noeud d'application du potentiel d'alimentation et la deuxième borne de la résistance fournissant la première tension de commande, et
- une deuxième résistance et un deuxième interrupteur en série entre la deuxième borne de la résistance fournissant la première tension de commande et le noeud d'application du potentiel de référence, une valeur de la deuxième résistance de l'ensemble étant identique à une valeur de la première résistance de l'ensemble.

Selon un mode de réalisation, le circuit de réglage comprend plusieurs desdits ensembles, et une valeur de la première résistance est différente dans chacun desdits ensembles.

Selon un mode de réalisation, la première tension de commande est déterminée par la différence entre la deuxième copie du premier courant et la copie du deuxième courant, et le circuit de réglage de la pente comprend un quatrième circuit configuré pour fournir la deuxième copie du premier courant, et un cinquième circuit configuré pour fournir la deuxième copie du deuxième courant, un gain du quatrième circuit et un gain du cinquième circuit étant réglables de sorte à permettre le réglage de la pente de la première tension de commande avec température.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de manière schématique et sous la forme de blocs, un exemple d'un circuit comprenant une capacité variable ;

la figure 2 représente, de manière schématique, un exemple de capacité variable ;

la figure 3 représente, de manière schématique, un autre exemple de capacité variable ;

la figure 4 illustre par des courbes un exemple de fonctionnement d'un exemple de circuit comprenant une capacité variable ;

la figure 5 représente, de manière schématique et en partie sous la forme de blocs, un mode de réalisation d'un dispositif ;

la figure 6 représente un exemple d'un autre mode de réalisation d'un circuit du dispositif de la figure 5 ;

la figure 7 représente un exemple d'encore un autre mode de réalisation du circuit de la figure 6 ;

la figure 8 représente un autre mode de réalisation d'un composant résistif du dispositif de la figure 5 ;

la figure 9 représente une variante de réalisation du circuit de la figure 5 ; et

la figure 10 représente un exemple de mode de réalisation d'un autre circuit du dispositif de la figure 5.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

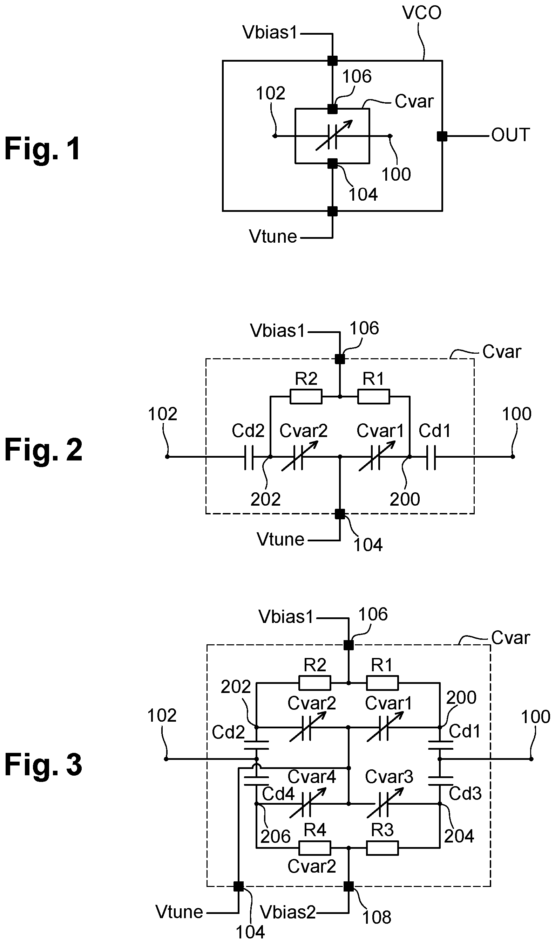

La figure 1 représente, de manière schématique et sous la forme de blocs, un exemple d'un circuit VCO comprenant une capacité variable Cvar.

Le circuit VCO est un oscillateur contrôlé en tension. Le circuit VCO est configuré pour fournir un signal OUT à une fréquence Fvco ayant une valeur déterminée par la valeur d'une tension de réglage Vtune. Plus particulièrement, la tension de réglage Vtune est une tension de réglage de la valeur de capacité de la capacité variable Cvar, et la valeur de la fréquence Fvco du signal OUT est déterminée au moins en partie par la valeur de capacité du composant Cvar. La tension Vtune est, par exemple, reçue par une borne 104 de la capacité Cvar.

Dans cet exemple, la capacité Cvar reçoit également une tension de polarisation Vbias1. La tension Vbias1 est, par exemple, reçue par une borne 106 de la capacité Cvar. La valeur de capacité de la capacité Cvar, par exemple entre deux bornes 100 et 102 du composant Cvar, est alors déterminée par la différence entre les tensions Vtune et Vbias1.

Bien que cela ne soit pas illustrée en figure 1, dans d'autres exemples, la capacité Cvar est configurée pour recevoir, en plus des tensions Vtune et Vbias1, une autre tension de polarisation Vbias2. Dans ces autres exemples, la valeur de capacité du composant Cvar est alors déterminée par la différence entre les tensions Vtune et Vbias1 et par la différence entre les tensions Vtune et Vbias2, l'écart entre les tensions Vbias1 et Vbias2 étant maintenu constant.

A titre d'exemple, la fréquence Fvco du signal OUT est asservie par une boucle à verrouillage de phase (non représentée en figure 1). La boucle à verrouillage de phase est, par exemple, configurée pour fournir, ou asservir, la tension Vtune de sorte que la fréquence Fvco soit égale à une fréquence de consigne Flock.

A titre d'exemple, le circuit VCO et la boucle à verrouillage de phase commandant la fréquence Fvco du signal OUT font partie d'un circuit radiofréquence et sont configurés pour que la fréquence Fvco du signal OUT soit supérieure à 1 GHz, de préférence supérieure à 10 GHz, par exemple environ égale à 20 GHz. A titre d'exemple, le circuit radiofréquence est un circuit de génération d'un signal d'horloge. A titre d'exemple alternatif ou complémentaire, le circuit radiofréquence fait partie d'un circuit d'émission et/ou de réception d'un signal radiofréquence sans fil.

La figure 2 représente, de manière schématique, un exemple de capacité variable Cvar.

Dans cet exemple, la capacité Cvar comprend deux composants Cvar1 et Cvar2 à capacité variable, par exemple deux varactors (ou diodes à capacité variable). La valeur de capacité de chacun des composants Cvar1 et Cvra2 est déterminée par la tension aux bornes de ce composant. Chacun des composants Cvar1 et Cvar2 a une électrode couplée, de préférence connectée, à la borne 104 recevant la tension Vtune, et une autre borne couplée à la borne 106 recevant la tension Vbias1. Par exemple, le dipôle Cvar1 est connecté entre la borne 104 et un noeud 200 couplé aux bornes 106 et 100, le dipôle Cvar2 étant connecté entre la borne 104 et un noeud 202 couplé aux bornes 106 et 102. Par exemple, le noeud 200, respectivement 202, est couplé à la borne 106 par une résistance R1, respectivement R2, la résistance R1, respectivement R2, étant par exemple connectée entre les noeuds 200 et 106, respectivement entre les noeuds 202 et 106. Par exemple, le noeud 200, respectivement 202, est couplé à la borne 100, respectivement 102, par une capacité de découplage Cd1, respectivement Cd2, la capacité Cd1, respectivement Cd2, étant par exemple connectée entre les noeuds 200 et 100, respectivement entre les noeuds 202 et 102.

La tension Vbias1 est une tension de polarisation du composant Cvar, et a généralement une valeur constante. En faisant varier la valeur de la tension Vtune, la tension aux bornes de chacun des composants Cvar1 et Cvar2 est alors modifiée, d'où il résulte une modification de la valeur de capacité de chacun des composants Cvar1 et Cvar2, donc de la valeur de capacité du composant Cvar.

La figure 3 représente, de manière schématique, un autre exemple de capacité variable Cvar.

La capacité Cvar de la figure 3 comprend tous les éléments de la capacité Cvar de la figure 2. Ainsi, sauf indication contraire, tout ce qui a été décrit pour la capacité Cvar de la figure 2 s'applique à la capacité Cvar de la figure 3.

En outre, la capacité Cvar de la figure 3 comprend deux composants Cvar3 et Cvar4 à capacité variable, par exemple deux varactors. La valeur de capacité de chacun des composants Cvar3 et Cvra4 est déterminée par la tension aux bornes de ce composant. Chacun des composants Cvar3 et Cvar4 a une électrode couplée, de préférence connectée, à la borne 104 recevant la tension Vtune, et une autre borne couplée à une borne 108 du composant Cvar, la borne 108 recevant la tension Vbias2. Par exemple, le dipôle Cvar3 est connecté entre la borne 104 et un noeud 204 couplé aux bornes 108 et 100, le dipôle Cvar4 étant connecté entre la borne 104 et un noeud 206 couplé aux bornes 108 et 102. Par exemple, le noeud 204, respectivement 206, est couplé à la borne 108 par une résistance R3, respectivement R4, la résistance R3, respectivement R4, étant par exemple connectée entre les noeuds 204 et 108, respectivement entre les noeuds 206 et 108. Par exemple, le noeud 204, respectivement 206, est couplé à la borne 100, respectivement 102, par une capacité de découplage Cd3, respectivement Cd4, la capacité Cd3, respectivement Cd4, étant par exemple connectée entre les noeuds 204 et 100, respectivement entre les noeuds 206 et 102.

La tension Vbias2 est une tension de polarisation du composant Cvar, et a généralement une valeur constante. En outre, l'écart entre les tensions Vbias1 et Vbias2 est de préférence constant. En faisant varier la valeur de la tension Vtune, la tension aux bornes de chacun des composants Cvar1, Cvar2, Cvar3 et Cvar4 est alors modifiée, d'où il résulte une modification de la valeur de capacité de chacun des composants Cvar1, Cvar2, Cvar3 et Cvar4, donc de la valeur de capacité du composant Cvar.

La capacité Cvar de la figure 3, du fait de la présence de deux tensions de polarisation Vbias1 et Vbias2 plutôt que de la seule tension de polarisation Vbias1 comme en figure 2, présente une variation de sa valeur de capacité avec la tension Vtune qui est plus linéaire que celle de la capacité Cvar de la figure 2. Ainsi, lorsque la capacité Cvar est utilisée pour régler la fréquence d'un oscillateur contrôlé en tension, la variation de de la fréquence de l'oscillateur avec la tension Vtune est plus linéaire lorsque la capacité Cvar de la figure 3 est utilisée que lorsque la capacité Cvar de la figure 2 est utilisée.

Comme cela a été mentionné précédemment, les circuits comprenant une capacité variable ont un fonctionnement qui peut dépendre de la température en plus de la valeur de leur capacité variable, ce qui pose problème. C'est par exemple le cas dans les oscillateurs contrôlés en tension, tel que l'oscillateur VCO de la figure 1, qui ont leur fréquence asservie par une boucle à verrouillage de phase.

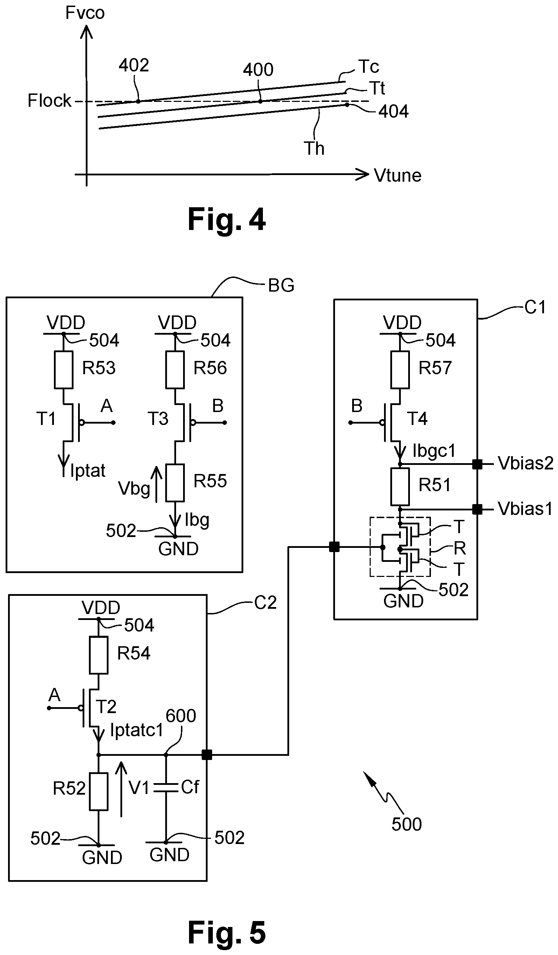

La figure 4 illustre par des courbes un exemple de fonctionnement de l'oscillateur VCO de la figure 1 lorsque l'oscillateur a sa fréquence Fvco asservie par une boucle à verrouillage de phase à la valeur de consigne Flock.

Une courbe Tt illustre l'évolution, à une température nominale de fonctionnement, par exemple la température ambiante, de la fréquence Fvco du signal OUT de l'oscillateur VCO en fonction de la tension Vtune.

Dans cet exemple, la fréquence Fvco augmente, par exemple de manière sensiblement linéaire, avec la valeur de la tension Vtune.

La boucle à verrouillage de phase commande la tension Vtune à une valeur telle que la fréquence Fvco est égale à la fréquence Flock (point 400 en figure 4). La boucle à verrouillage de phase est alors dite verrouillée.

Une courbe Tc illustre l'évolution de la fréquence Fvco du signal OUT de l'oscillateur VCO en fonction de la tension Vtune, à une température basse plus faible que la température nominale. Une courbe Th illustre l'évolution de la fréquence Fvco du signal OUT de l'oscillateur VCO en fonction de la tension Vtune, à une température haute, plus élevée que la température ambiante.

Dans cet exemple, pour une valeur de tension Vtune donnée, la fréquence Fvco diminue quand la température augmente. La courbe Tc correspond alors à une translation de la courbe Tt vers des fréquences Fvco plus élevées, et la courbe Th correspond alors à une translation de la courbe Tt vers des fréquences Fvco plus basses.

Comme la fréquence Fvco de l'oscillateur VCO est asservie à la valeur Flock par la boucle à verrouillage de phase, dans cet exemple où la fréquence Fvco augmente avec l'augmentation de la tension Vtune et diminue avec l'augmentation de la température, la boucle diminue la valeur de la tension Vtune lorsque la température diminue pour maintenir la fréquence Fvco égale à la fréquence Flock. En particulier, à la température basse correspondant à la courbe Tc, la tension Vtune est diminuée jusqu'à une valeur correspondant à un point 402 en figure 4, pour laquelle la courbe Tc prend la valeur Flock. De manière symétrique, la boucle augmente la valeur de la tension Vtune lorsque la température augmente pour maintenir la fréquence Fvco égale à la fréquence Flock. En particulier, à la température haute correspondant à la courbe Tc, la tension Vtune est augmentée jusqu'à une valeur correspondant à un point 404 de la courbe Th. Cependant, comme cela est illustré en figure 4, au point 404 correspondant à la valeur maximale que peut prendre la tension Vtune, la fréquence Fvco est inférieure à la fréquence Flock, et la boucle à verrouillage de phase n'est plus verrouillée.

Le fait que la boucle à verrouillage de phase ne puisse plus être verrouillée lorsque la température varie par rapport à la température nominale de fonctionnement peut se poser lorsque la température augmente ou diminue par rapport à la température nominale, dans des circuits où la fréquence Fvco augmente quand la tension Vtune augmente comme cela est illustré en figure 4, mais également dans des circuits où la fréquence Fvco diminue quand la tension Vtune augmente, et/ou dans des circuits où la fréquence Fvco augmente quand la température diminue comme cela est illustré en figure 4, mais également dans des circuits où la fréquence Fvco diminue quand la température diminue.

A titre d'exemple, la variation de la fréquence Fvco avec la température est liée au moins en partie à la variation de la valeur de capacité du composant Cvar avec la température, et, plus généralement, à la variation avec la température des valeurs des composants de la cellule ("tank" en anglais) de l'oscillateur.

Pour réduire la dépendance de la fréquence Fvco à la température, c'est à dire pour rapprocher les courbes Tc et Th de la courbe Tt, on pourrait penser à remplacer le composant Cvar du circuit VCO par deux composants Cvar en parallèle, l'un étant commandé par la tension Vtune comme cela a été précédemment décrit, et l'autre étant commandé par une tension déterminée par la température de sorte à compenser la variation de la fréquence Fvco avec la température.

Toutefois, en plus d'augmenter la surface de la capacité Cvar, donc du circuit VCO, cela augmente le nombre de capacités parasites, ce qui pose problème, par exemple en particulier dans le domaine radiofréquence.

Alors que de manière usuelle la ou les tensions Vbias1 et Vbias2 de polarisation d'une capacité variable sont constantes et ne dépendent pas de la température, il est ici proposé de les rendre dépendantes de la température.

Par exemple, il est ici proposé de rendre la tension Vbias1 de polarisation d'une capacité variable ne recevant qu'une tension de polarisation, ou les deux tensions Vbias1 et Vbias2 de polarisation d'une capacité variable recevant deux tensions de polarisation, dépendantes de la température. La façon dont cette ou ces tensions de polarisation dépendent de la température (augmente ou diminue avec la température) est déterminée de sorte à compenser l'effet de la variation de la température sur le fonctionnement d'un circuit électronique comprenant une capacité variable ayant sa valeur de capacité déterminée par la différence entre une tension de commande Vtune et chaque tension de polarisation qu'elle reçoit. Selon un mode de réalisation où la capacité variable reçoit deux tensions de polarisation, il est prévu que l'écart entre les deux tensions de polarisation reste constant lorsque la température varie.

Ainsi, il est ici proposé un dispositif configuré pour fournir une ou plusieurs tensions de polarisation d'une capacité variable qui dépendent chacune de la température, par exemple de manière à compenser l'effet de la variation de la température sur le fonctionnement d'un circuit comprenant une telle capacité variable. Le choix de la façon dont chacune des tensions de polarisation de la capacité variable varie avec la température, par exemple augmente quand la température augmente ou diminue quand la température augmente, dépend de l'application. Par exemple, le choix de la façon dont chacune des tensions de polarisation varie en fonction de la température est fait de manière à compenser des variations en température d'un paramètre ayant une valeur au moins en partie déterminée par celle de la capacité.

A titre d'exemple, le circuit est un oscillateur, par exemple configuré pour fournir un signal radiofréquence, et la capacité variable fait partie de la cellule ("tank" en anglais) de l'oscillateur. La variation des tensions de polarisation de la capacité variable avec la température est alors configurée pour compenser une variation de la fréquence Fvco de l'oscillateur avec la température. En effet, la fréquence Fvco dépend de la valeur de la capacité de la cellule ("tank" en anglais) de l'oscillateur et, plus généralement, de la valeur de chacun des composants de cette cellule ("tank" en anglais), et les valeurs de ces composants varient avec la température.

La figure 5 représente, de manière schématique et en partie sous la forme de blocs, un mode de réalisation d'un tel dispositif 500.

Le dispositif 500 comprend un circuit à bande interdite ("band-gap circuit" en anglais) référencé BG en figure 5.

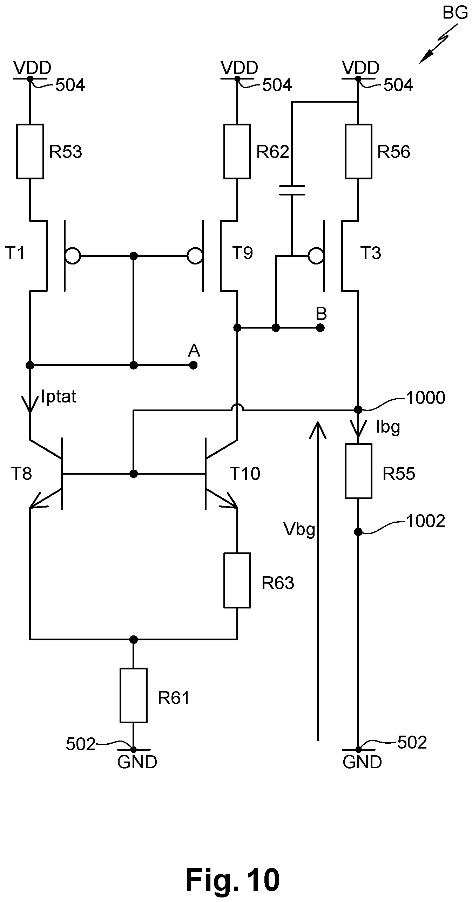

Le circuit BG comprend un élément résistif R55 et est configuré pour appliquer une tension stable en température aux bornes de l'élément résistif R55, de sorte qu'un courant Ibg y circule. Dit autrement, le circuit BG est configuré pour générer la tension Vbg stable en température, et pour imposer cette tension aux bornes de l'élément résistif R55. Un exemple détaillé de circuit BG sera décrit dans la suite en relation avec la figure 10. En plus du courant Ibg, le circuit BG est en outre configuré pour fournir un courant Iptat dépendant de la température, de préférence de manière linéaire avec la température. Le courant Iptat est un courant proportionnel à la température absolue (PTAT de l'anglais "Proportionnal To Absolute Température") qui augmente quand la température augmente.

Le dispositif 500 comprend également un circuit C1. Le circuit C1 comprend un élément résistif R. L'élément résistif R a une borne connectée à un noeud 502 configuré pour recevoir un potentiel de référence GND, par exemple la masse. L'élément R est configuré pour fournir la tension Vbias1, cette tension Vbias1 étant alors disponible aux bornes de l'élément R. La tension Vbias1 est une tension de polarisation d'une capacité variable, par exemple d'une capacité variable Cvar.

L'élément R comprend, de préférence est constitué par, un ou plusieurs transistors MOS (de l'anglais "Métal Oxide Semiconductor" - métal oxyde semiconducteur) en série entre les bornes de conduction de l'élément résistif R. Chacun de ces transistors T est monté en diode, c'est à dire a son drain connecté à sa grille. Lorsque le composant R comprend plusieurs transistors T, ces derniers sont tous du même type, par exemple sont tous des transistors NMOS comme c'est le cas dans l'exemple de la figure 5 où le composant R comprend exactement deux transistors T à canal N (ou NMOS). De préférence, les transistors T sont tous identiques. A titre d'exemple, un avantage de mettre en oeuvre l'élément résistif R avec Q transistors T en série montés chacun en diode est que la résistance en petit signal est en Q/gm et est donc faible, Q étant un entier supérieur ou égal à 1, et gm étant la transconductance d'un transistor T. Il en résulte un faible bruit sur les tensions disponibles sur les bornes de l'élément résistif R.

Le circuit C1 est connecté au circuit BG et est configuré pour fournir une copie Ibgc1 du courant Ibg à l'élément résistif R. Dit autrement, le circuit C1 est configuré pour fournir un courant Ibgc1 qui est une copie du courant Ibg, et pour que ce courant Ibgc1 circule entre les bornes de conduction du composant R.

Dans la suite de la présente description, sauf indication contraire, lorsqu'il est indiqué qu'un premier courant est une copie d'un deuxième courant cela signifie que le premier courant est égal au deuxième courant à un facteur multiplicatif près.

Le dispositif 500 comprend en outre un circuit C2. Le circuit C2 est connecté au circuit BG. Le circuit C2 est configuré pour fournir une tension de polarisation V1 aux grilles arrière des transistors T de l'élément R qui soit dépendante de la température. Ainsi, lorsque la température varie, la tension V1 varie ce qui modifie la valeur de résistance de chacun des transistors T, donc la valeur de la tension Vbias1 disponible aux bornes de l'élément R, c'est à dire la tension Vbias1 disponible sur la borne de l'élément R qui n'est pas connectée au noeud 502.

Les transistors T ayant des grilles arrière, ils sont donc mis en oeuvre sur semiconducteur sur isolant (SOI de l'anglais "Semiconductor On Insulator"), par exemple sur silicium complètement déplété sur isolant (FDSOI de l'anglais "Fully Depleted Silicon On Insulator").

Dans le mode de réalisation de la figure 5, le circuit C2 est plus particulièrement configuré pour fournir une copie Iptatc1 du courant Iptat et pour que la tension V1 soit déterminée par le courant Iptatc1, par exemple varie linéairement avec ce courant Iptatc1. Ainsi, lorsque la température varie, le courant Iptat varie, d'où il résulte que le courant Iptatc1 varie ce qui entraîne une variation correspondante de la tension V1. La variation de la tension V1 résulte en une variation de la valeur de résistance du composant R, donc en une variation correspondante de la tension Vbias1. Il s'ensuit que, en ne modifiant pas la valeur de la tension Vtune, la valeur de capacité d'une capacité variable telle que celle de la figure 2 est modifiée lorsque la température varie.

Dans le mode de réalisation illustré par la figure 5, le dispositif 500 est configuré pour fournir également la tension de polarisation Vbias2 en plus de la tension Vbias1. Les tensions Vbias1 et Vbias2 sont des tensions de polarisation d'une capacité variable, par exemple de la capacité variable Cvar de la figure 3. Pour cela, dans le circuit C1, l'élément résistif R est connecté en série avec une résistance R51. Ainsi, une borne de l'élément R est connectée au noeud 502, une autre borne de l'élément R est connectée à une borne de la résistance R51 et fournit la tension Vbias1, et l'autre borne de la résistance R51 fournit la tension Vbias2. De préférence, la résistance R51 est appairée ("matched" en anglais) à la résistance R55, d'où il résulte que l'écart entre les tensions Vbias1 et Vbias2 est constant et, en particulier, ne dépend pas de la température du fait que le courant Ibgc1 est une copie du courant Ibg égal à Vbg/R55.

Selon un mode de réalisation, lorsque le dispositif 500 est configuré pour fournir les deux tensions Vbias1 et Vbias2, le dispositif 500 comprend une capacité variable (non représentée en figure 5) configurée pour recevoir les tensions de polarisation Vbias1 et Vbias2 et la tension de réglage Vtune et ayant sa valeur de capacité déterminée par la différence entre les tensions Vbias1 et Vtune et par la différence entre les tensions Vbias2 et Vtune. A titre d'exemple, cette capacité variable est la capacité Cvar décrite en relation avec la figure 3. Selon un mode de réalisation, le dispositif comprend en outre un oscillateur contrôlé en tension, par exemple l'oscillateur VCO de la figure 1, comprenant cette capacité variable. Selon un mode de réalisation, le dispositif comprend un circuit de fourniture de la tension Vtune, par exemple une boucle à verrouillage de phase.

Dans un autre mode de réalisation non illustré, le dispositif 500 est configuré pour ne fournir que la tension de polarisation Vbias1. Dans cet autre mode de réalisation, la résistance R51 peut être omise.

Selon un mode de réalisation, lorsque le dispositif 500 est configuré pour fournir seulement la tension de polarisation Vbias1, le dispositif 500 comprend une capacité variable configurée pour recevoir la tension Vbias1 et une tension de réglage Vtune, et ayant sa valeur de capacité déterminée par la différence entre les tensions Vbias1 et Vtune. A titre d'exemple, cette capacité variable est la capacité Cvar décrite en relation avec la figure 2. Selon un mode de réalisation, le dispositif comprend en outre un oscillateur contrôlé en tension, par exemple l'oscillateur VCO de la figure 1, comprenant cette capacité variable. Selon un mode de réalisation, le dispositif comprend un circuit de fourniture de la tension Vtune, par exemple une boucle à verrouillage de phase.

Selon un mode de réalisation, comme cela est illustré en figure 5, le circuit C2 comprend une résistance R52 configurée pour fournir la tension V1. La résistance R52 a une borne connectée au noeud 502 et une autre borne connectée à la grille arrière des transistors T (ou noeud 600), la tension V1 étant disponible sur cette autre borne. Dans l'exemple de mode de réalisation de la figure 5, le circuit C2 est configuré pour fournir le courant Iptatc1 au noeud 600. Le courant Iptatc1 circule alors entre les bornes de la résistance R52 qui convertit le courant Iptatc1 en la tension V1.

A titre d'exemple, la résistance R52 a une valeur telle que, à la température nominale de fonctionnement, la tension V1 soit égale à la moitié d'un potentiel d'alimentation VDD du dispositif 500, le potentiel VDD étant de préférence positif et référencé au potentiel GND.

De préférence, le circuit C2 comprend une capacité de lissage Cf connectée entre le noeud 600 et le noeud 502.

A titre d'exemple, le circuit BG comprend un transistor MOS à canal P T1 configuré pour que le courant Iptat y circule, et le circuit C2 comprend un transistor MOS à canal P T2 monté en miroir du transistor T1 de sorte que le transistor T2 fournisse le courant Iptatc1 au noeud 600. Le transistor T2 est, dans l'exemple de la figure 5, connecté au noeud 600 et en série avec la résistance R52 configurée pour fournir la tension V1.

A titre d'exemple plus détaillé, le transistor T1 a sa source couplée à un noeud 504 configuré pour recevoir le potentiel d'alimentation VDD, par exemple par une résistance R53, la résistance R53 ayant, de préférence, une borne connectée au transistor T1 et une borne connectée au noeud 504. La grille du transistor T1 est connectée à un noeud A. Le transistor T2 a alors sa grille connectée au noeud A et sa source couplée au noeud 504, par exemple par une résistance R54, la résistance R54 ayant, de préférence, une borne connectée au transistor T2 et une borne connectée au noeud 504.

A titre d'exemple, le circuit BG comprend en outre un transistor MOS à canal P T3 configuré pour que le courant Ibg y circule, et le circuit C1 comprend un transistor MOS à canal P T4 monté en miroir du transistor T3 de sorte que le transistor T4 fournisse le courant Ibgc1. Le transistor T4 est connecté en série avec l'élément résistif R. Le transistor T3 est, par exemple, connecté en série avec l'élément résistif R55 aux bornes de duquel le circuit BG applique la tension stable en température Vbg. L'élément résistif R55, par exemple une résistance, a une borne connectée au noeud 502. Il en résulte que le courant Ibg circule entre les bornes de l'élément R55, c'est à dire dans l'élément R55, et dans le transistor T3 connecté en série avec l'élément R55 entre les noeuds 504 et 502. Le transistor T3 a sa source couplée au noeud 504, par exemple par une résistance R56, la résistance R56 ayant une borne connectée au transistor T3 et une borne connectée au noeud 504. La grille du transistor T3 est connectée à un noeud B. Le transistor T4 a alors sa grille connectée au noeud B et sa source couplée au noeud 504, par exemple par une résistance R57, la résistance R57 ayant, de préférence, une borne connectée au transistor T4 et une borne connectée au noeud 504. Le transistor T4 est en série avec la résistance R57 entre les noeuds 504 et 502.

Dans l'exemple de mode de réalisation décrit en relation avec la figure 5, le circuit C2 est configuré pour fournir le courant Iptatc1 copie du courant Iptat, fournir la tension V1 déterminée par le courant Iptatc1, et appliquer la tension V1 à la grille arrière des transistors T de l'élément résistif R.

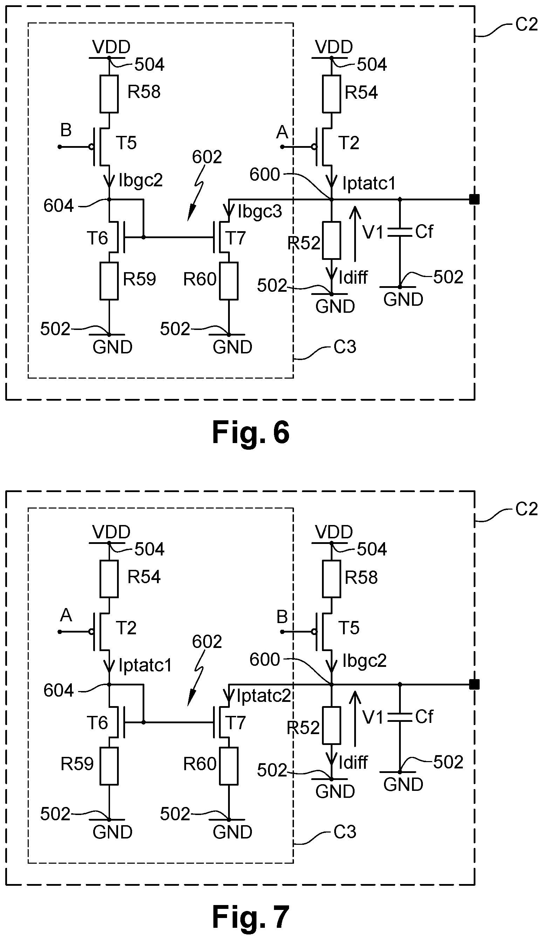

Dans d'autres exemples de modes de réalisation, comme cela va être décrit en relation avec les figures 6 et 7, le circuit C2 est configuré pour fournir une copie du courant Ibg au noeud 600 et une copie du courant Iptat au noeud 600, fournir la tension V1 qui est alors déterminée par une différence entre ces deux copies de courant, et appliquer la tension V1 à la grille arrière des transistors T de l'élément résistif R.

La figure 6 représente un exemple d'un tel mode de réalisation du circuit C2.

Le circuit C2 de la figure 6 comprend, comme l'exemple de circuit C2 décrit en relation avec la figure 5, le transistor T2 configuré pour fournir le courant Iptatc1. Le transistor T2 a sa source couplée au noeud 504, par exemple par la résistance R54, et son drain couplé, par exemple connecté, au noeud 600 correspondant au noeud de connexion du transistor T2 à la résistance R52.

Le circuit C2 comprend en outre un circuit C3 configuré pour fournir une copie Ibgc3 du courant Ibg.

Le courant Ibgc3 est fourni au noeud 600 de sorte qu'un courant Idiff circulant dans la résistance R52 soit égal à la différence entre les courants Iptatc1 et Ibgc3. Plus exactement, dans l'exemple de la figure 6, le circuit C3 est configuré pour que le courant Idiff soit égal au courant Iptatc1 moins le courant Ibgc3. Ainsi, lorsque la température augmente, le courant Idiff augmente, d'où il résulte que la tension V1 augmente.

A titre d'exemple, le circuit C3 comprend un transistor MOS à canal P T5 configuré pour fournir une copie Ibgc2 du courant Ibg, le transistor T5 étant monté en miroir du transistor T3. Par exemple, le transistor T5 a sa source couplée au noeud 504, par exemple par une résistance R58, la résistance R58 ayant, de préférence, une borne connectée au transistor T5 et une borne connectée au noeud 504. La grille du transistor T5 est connectée au noeud B. Le drain du transistor T5 est couplé au noeud 600.

Dans l'exemple de la figure 6, le transistor T5 est couplé au noeud 600 par un miroir de courant 602 à transistor MOS à canal N, le miroir de courant 602 étant ici configuré pour fournir le courant Ibgc3 à partir du courant Ibgc2. Par exemple, le miroir de courant 602 comprend un transistor MOS à canal N T6 ayant son drain connecté à un noeud 604 et sa source couplée au noeud 502, par exemple par une résistance R59, la résistance R59 ayant par exemple une borne connectée au noeud 502 et une borne connectée à la source du transistor T6. La grille du transistor T6 est connectée au drain du transistor T6. Le miroir de courant 602 comprend en outre un transistor MOS à canal N T7 ayant son drain connecté au noeud 600 et sa source couplée au noeud 502, par exemple par une résistance R60, la résistance R60 ayant par exemple une borne connectée au noeud 502 et une borne connectée à la source du transistor T7. La grille du transistor T7 est connectée à la grille du transistor T6. Dans l'exemple de la figure 6, le transistor T5 est connecté au noeud 604 par son drain.

La figure 7 représente un exemple d'un autre mode de réalisation du circuit C2.

Par rapport à la figure 6, dans l'exemple de la figure 7 le circuit C2 est configuré pour que le courant Idiff dans la résistance R52 soit égal à la différence entre la copie Ibgc2 du courant Ibg et une copie Iptatc2 du courant Iptat, et, plus exactement, pour que le courant Idiff soit égal au courant Ibgc2 moins le courant Iptatc2. Ainsi, lorsque la température augmente, le courant Idiff diminue, d'où il résulte que la tension V1 diminue.

Le circuit C2 de la figure 7 diffère donc du circuit C2 de la figure 6 en ce que :

- le transistor T2 configuré pour fournir le courant Iptatc1 au noeud 600 dans le circuit C2 de la figure 6 a été remplacé par le transistor T5 configuré pour fournir le courant Ibgc2 dans le circuit C2 de la figure 7, de sorte que le courant Ibgc2 soit fourni au noeud 600 ; et
- le circuit C3 du circuit C2 de la figure 7 n'est pas configuré pour fournir le courant Ibgc3 au noeud 600, comme c'était le cas en figure 6, mais pour fournir le courant Iptatc2 au noeud 600.

Par exemple, le transistor T5 reste monté en miroir du transistor T3, avec sa grille connectée au noeud B, sa source couplée au noeud 504, par exemple par la résistance R58, mais son drain est connecté au noeud 600 plutôt qu'au noeud 604 comme c'était le cas en figure 6. De manière symétrique, le transistor T2 reste monté en miroir du transistor T1, avec sa grille connectée au noeud A, sa source couplée au noeud 504, par exemple par la résistance R54, mais son drain est connecté au noeud 604 couplé au noeud 600 par le miroir de courant 602. Le miroir de courant 602 fournit alors le courant Iptatc2 à partir du courant Iptatc1.

Dans le dispositif 500 décrit ci-dessus en relation avec les figures 5 à 7, l'élément résistif est composé de transistors MOS en série et montés chacun en diode. Cela permet de réduire le bruit sur la tension Vbias1 par rapport à un dispositif dans lequel un courant dépendant de la température aurait été directement fourni à une résistance pour obtenir la tension Vbias aux bornes de cette résistance.

En outre, la prévision du composant R tel que décrit permet d'adapter le gain entre une variation de température et une variation correspondante de la tension Vbias1 en modifiant le nombre de transistor T du composant R.

Dans les exemples de modes de réalisation et variantes décrits ci-dessus, le composant R comprend, de préférence est constitué par un ou plusieurs transistors MOS T à canal N.

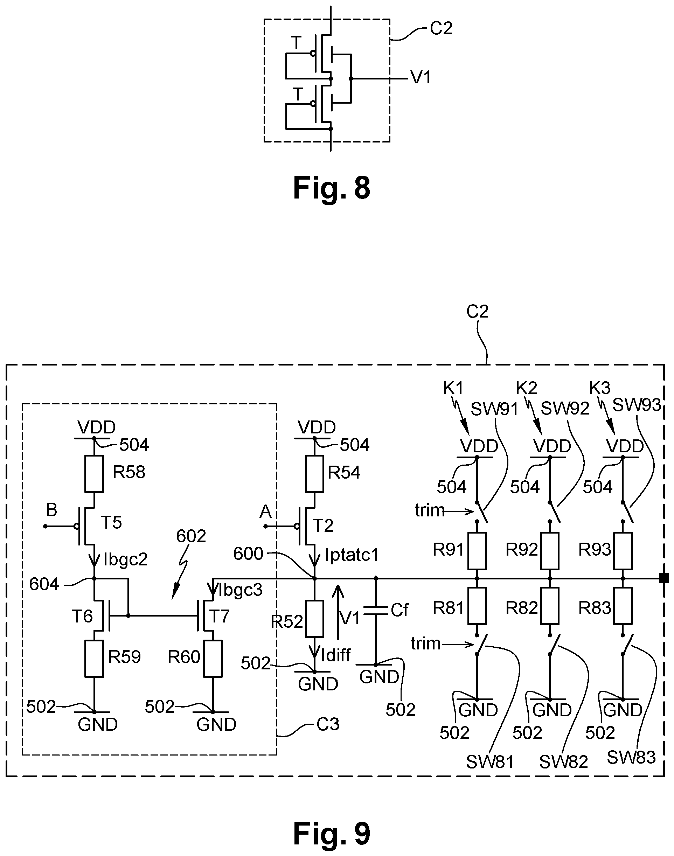

La figure 8 représente un autre mode de réalisation du composant résistif R du dispositif de la figure 5.

Dans le composant R du mode de réalisation de la figure 8, chaque transistor T du composant R est à canal P plutôt qu'à canal N comme cela a été décrit précédemment.

Bien que cela ne soit illustré en figure 8, le drain des transistors T est alors du côté du noeud 502. Par exemple, le transistor T de l'élément résistif R qui a une borne connectée au noeud 502 a son drain connecté au noeud 502.

Par rapport au cas où les transistors T sont à canal N, le sens de variation de la tension V1 avec la température est inversé pour un cas correspondant où les transistors T sont à canal P, de sorte que le sens de variation de la tension Vbias1 avec la température reste le même.

La figure 9 représente une variante de réalisation du circuit C2. En figure 9, la variante de réalisation est appliquée au circuit C2 de la figure 6, bien que cette variante puisse également s'appliquer au circuit C2 de la figure 7, cette dernière mise en oeuvre étant à la portée de la personne du métier à partir de la description faite ci-dessous en relation avec la figure 9.

Dans cette variante, le circuit C2 comprend un circuit de réglage de la pente de la tension V1 avec la température, donc de la pente de la tension Vbias1 avec la température. Cela permet d'ajuster la façon dont la variation de la fréquence Fvco avec la température est compensée par la variation de la tension Vbias1 avec la température, par exemple de sorte que, pour une tension Vtune donnée, la variation de la fréquence Fvco avec la température soit aussi faible que possible.

Plus particulièrement, dans l'exemple de la figure 9, ce circuit de réglage comprend plusieurs ensembles Ki, avec i un indice entier strictement positif. Dans l'exemple de la figure 9, i est égal à 3.

Chaque ensemble Ki (K1, K2, K3 en figure 9) comprend :

- une résistance R8i (R81, R82, R83 en figure 9) et un interrupteur SW8i (SW81, SW82, SW83 en figure 9) connectés en série entre le noeud 600 et le noeud 502 ; et
- une résistance R9i (R91, R92, R93 en figure 9) et un interrupteur SW9i (SW91, SW92, SW93 en figure 9) connectés en série entre le noeud 600 et le noeud 504.

A titre d'exemple, dans chaque ensemble Ki, l'interrupteur SW8i est connecté au noeud 502 et l'interrupteur SW9i est connecté au noeud 504.

Dans chaque ensemble Ki, la résistance R8i de l'ensemble est identique à la résistance R9i de cet ensemble Ki. Par exemple, chaque résistance R8i est appairée ("matched" en anglais) à la résistance R9i correspondante. En outre, pour chaque ensemble Ki, la valeur des résistances R8i et R9i de l'ensemble Ki est de préférence différente de celle des résistances R8i et R9i des autres ensembles Ki.

A titre d'exemple, dans une configuration dite "binaire", pour i supérieur ou égal à 2, la valeur de la résistance R9i, respectivement R8i, d'indice i est égale à deux fois la valeur de la résistance R9i-1, respectivement R8i-1, d'indice i-1. Par exemple, dans chaque ensemble Ki, la valeur des résistances R8i et R9i de l'ensemble est un multiple de la valeur de la résistance R52. Par exemple, dans chaque ensemble Ki, la valeur des résistances R8i et R9i est égale à $2^{(i-1)}$ fois la valeur de la résistance R52.

A titre d'autre exemple, dans une configuration dite "thermométrique", la valeur de chaque résistance R8i, respectivement R9i, est déterminée, par exemple lors d'une phase de réglage ou d'étalonnage, indépendamment de la valeur des autres résistances R8i, respectivement R9i.

Les interrupteurs SW8i et SW9i des ensembles Ki sont commandés par un signal numérique trim fourni par un circuit non représenté. Par exemple, le signal trim comprend i bits, chaque bit du signal trim contrôlant un ensemble Ki correspondant. Le signal trim est configuré pour que les interrupteurs SW9i et SW8i d'un même ensemble Ki soient dans le même état passant ou bloqué.

Dans un autre exemple non illustré de mise en oeuvre du circuit de réglage de la pente de la tension Vbias1 avec la température, le circuit de réglage comprend :

> un circuit configuré pour fournir la copie du courant Iptat au noeud 600, à savoir le transistor T2 fournissant la copie Iptatc1 dans le mode de réalisation de la figure 6 et le circuit C3 fournissant la copie Iptatc2 dans le mode de réalisation de la figure 7 ; et
> un circuit configuré pour fournir la copie du courant Ibg au noeud 600, à savoir le circuit C3 fournissant la copie Ibgc3 dans le mode de réalisation de la figure 6, et le transistor T5 fournissant la copie Ibgc2 dans le mode de réalisation de la figure 7, et, en outre, le gain du circuit fournissant la copie du courant Ibg au noeud 600 est réglable tout comme le gain du circuit fournissant la copie du courant Iptat au noeud 600.

De cette façon, le réglage des gains de ces deux circuits permet de régler ou ajuster la pente de la tension V1, donc de la tension Vbias1, avec la température.

Dans les modes de réalisation décrits, lorsque la copie Iptatc1 du courant Iptat qui est fournie au noeud 600 correspond à un courant positif (cas de la figure 6), la tension V1 augmente avec la température. A l'inverse, lorsque la copie Iptatc2 du courant Iptat qui est fournie au noeud 600 correspond à un courant négatif, c'est à dire un courant positif Iptatc2 tiré sur le noeud 600 (cas de la figure 7), la tension V1 diminue avec la température.

On considère à titre d'exemple le cas où le circuit configuré pour fournir la copie du courant Iptat au noeud 600 comprend le transistor T2 en série avec la résistance R52 (figure 6) et où le circuit configuré pour fournir la copie du courant Ibg au noeud 600 correspond au circuit C3 de la figure 6. Dans cet exemple, le transistor T2 est mis en oeuvre par plusieurs transistors MOS à canal P sélectivement connectés en parallèle les uns des autres par des interrupteurs commandés par un premier signal de commande, de sorte que le courant Iptatc1 fourni par le transistor T2 au noeud 600 soit égal à $\alpha$*Iptatunit, avec $\alpha$ un facteur, de préférence entier, dont la valeur dépend de l'état du premier signal de commande, et Iptatunit un courant déterminé par le courant Iptat, par exemple proportionnel ou égal au courant Iptat. Toujours dans cet exemple, le transistor T7 (ou de manière alternative le transistor T5, bien que cela puisse entraîner que la tension de saturation drain source du transistor T7 ne soit pas constante, ce qui entraîne des problèmes de saturation du transistor T7 pour des courants élevés) est mis en oeuvre par plusieurs transistors MOS à canal N (à canal P lorsque cela concerne le transistor T5) sélectivement connectés en parallèle les uns des autres par des interrupteurs commandés par un deuxième signal de commande, de sorte que le courant Ibgc3 fourni par le transistor T7 au noeud 600 soit égal à $\beta$*Ibgunit, avec $\beta$ un facteur, de préférence entier, dont la valeur dépend de l'état du deuxième signal de commande, et Ibgunit un courant déterminé par le courant Ibg, par exemple proportionnel ou égal au courant Ibg. La modification des valeurs des gains $\alpha$ et $\beta$ permet alors de régler la pente de la tension V1, donc de la tension Vbias1, avec la température.

De préférence, dans l'exemple ci-dessus, les valeurs des gains $\alpha$ et $\beta$ et des courants Ibgunit et Iptatunit sont configurés pour que, à la température nominale de fonctionnement, la tension V1 soit égal à VDD/2. Dit autrement, les gains $\alpha$ et $\beta$ sont choisis pour que, à la température nominale de fonctionnement, $\alpha$*Iptatunit - $\beta$*Ibgunit = VDD/(2*R52), ce qui fixe la relation entre $\alpha$ et $\beta$, par exemple car les courants Iptatunit et Ibgunit à la température nominale sont connus. Par exemple, lorsqu'à la température nominale de fonctionnement Iptatunit est égal à Ibgunit et à courant Idiff avec V1 égale à VDD/2, les gains $\alpha$ et $\beta$ vérifient

$$\alpha - \beta = 1.$$

On considère à titre d'autre exemple le cas où le circuit configuré pour fournir la copie du courant Iptat au noeud 600 correspond au circuit C3 (figure 7) et où le circuit configuré pour fournir la copie du courant Ibg au noeud 600 comprend le transistor T5 en série avec la résistance R52 (figure 7). Dans cet exemple, le transistor T5 est mis en oeuvre par plusieurs transistors MOS à canal P sélectivement connectés en parallèle les uns des autres par des interrupteurs commandés par un premier signal de commande, de sorte que le courant Ibgc2 fourni par le transistor T5 au noeud 600 soit égal à $\beta$*Ibgunit, avec $\beta$ un facteur, de préférence entier, dont la valeur dépend de l'état du premier signal de commande, et Ibgunit un courant déterminé par le courant Ibg, par exemple proportionnel ou égal au courant Ibg. Toujours dans cet exemple, le transistor T7 (ou de manière alternative le transistor T2, bien que cela puisse entraîner que la tension de saturation drain source du transistor T7 ne soit pas constante, ce qui entraîne des problèmes de saturation du transistor T7 pour des courants élevés) est mis en oeuvre par plusieurs transistors MOS à canal N (à canal P lorsque cela concerne le transistor T2) sélectivement connectés en parallèle les uns des autres par des interrupteurs commandés par un deuxième signal de commande, de sorte que le courant Ipatc2 fourni par le transistor T7 au noeud 600 soit égal à α*Iptatunit, avec α un facteur, de préférence entier, dont la valeur dépend de l'état du deuxième signal de commande, et Iptatunit un courant déterminé par le courant Iptat, par exemple proportionnel ou égal au courant Iptat. La modification des valeurs des gains α et β permet alors de régler la pente de la tension V1, donc de la tension Vbias1, avec la température.

De préférence, dans l'exemple ci-dessus, les valeurs des gains α et β et des courants Ibgunit et Iptatunit sont configurés pour que, à la température nominale de fonctionnement, la tension V1 soit égal à VDD/2. Dit autrement, les gains α et β sont choisis pour que, à la température nominale de fonctionnement, β*Ibgunit - α*Iptatunit = VDD/(2*R52), ce qui fixe la relation entre α et β, par exemple car les courants Iptatunit et Ibgunit à la température nominale sont connus. Par exemple, lorsqu'à la température nominale de fonctionnement Iptatunit est égal à Ibgunit et à courant Idiff avec V1 égale à VDD/2, les gains α et β vérifient

$$\beta - \alpha = 1.$$

Dans les modes de réalisation et variante décrits ci-dessus, la résistance R52 est connectée entre le noeud 600 et le noeud 502. Dans d'autres modes de réalisation et variantes, par rapport à ce qui a été décrit précédemment, la résistance R52 est connectée entre le noeud 600 et le noeud 504. La mise en oeuvre de ces autres modes de réalisation et variantes est à la portée de la personne du métier à partir des indications fonctionnelles données ci-dessus.

La figure 10 illustre un exemple d'un circuit BG pouvant être utilisé pour mettre en oeuvre le dispositif 500, étant entendu que la personne du métier pourra prévoir d'utiliser d'autres circuits BG.

Dans cet exemple, le circuit BG comprend le transistor T1 ayant sa source couplée au noeud 504, par exemple par la résistance R53, sa grille connectée au noeud A, et son drain connecté à sa grille, ainsi que le transistor T3 ayant sa source couplée au noeud 504, par exemple par la résistance R56, sa grille connectée au noeud B et son drain connecté à une borne 1000 de la résistance R55, l'autre borne 1002 de la résistance R55 étant connectée au noeud 502. A titre d'exemple, une capacité de compensation est connectée entre la grille B du transistor T3 et le noeud 504, pour améliorer la stabilité.

Le circuit BG comprend en outre un transistor bipolaire NPN T8 couplant le drain A du transistor T1 au noeud 502. Le transistor T8 a, par exemple, son collecteur connecté au noeud A, et son émetteur couplé au noeud 502 par une résistance R61. La base du transistor T8 est connectée à la borne 1000 de la résistance R55.

Le circuit BG comprend aussi un transistor MOS à canal P T9 monté en miroir du transistor T1. Le transistor T9 a, par exemple, sa grille connectée au noeud A, sa source couplée au noeud 502, par exemple par une résistance R62 de préférence connectée entre le noeud 504 et le transistor T9. Un transistor bipolaire NPN T10 du circuit BG couple le drain du transistor T9 à la résistance R61. Le transistor T10 a sa base connectée à la base du transistor T8, et, par exemple, son collecteur connecté au drain du transistor T9 et son émetteur couplé à la résistance R61, par exemple par une résistance R63 ayant de préférence une borne connectée au transistor T10 et une autre borne connectée à la résistance R61.

Les transistors T1, T8, T9 et T10, et les résistances R53, R61, R62 et R63 sont dimensionnées pour que la tension Vbg sur la borne 1000 de la résistance R55 soit stable en température, c'est à dire constante avec la température. En outre, les transistors bipolaires T8 et T10 sont par exemple dimensionnés de sorte que le courant dans le transistor T8 soit de type PTAT. Par exemple, le transistor T10 est mis en oeuvre par une connexion en parallèle de plusieurs transistors identiques au transistor T8, de sorte que la tension aux bornes la résistance R63 soit de type PTAT.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif (500) comprenant :

   un premier circuit à bande interdite (BG) configuré pour appliquer une tension (Vbg) stable en température aux bornes d'un premier élément résistif de sorte qu'un premier courant (Ibg) y circule, et pour fournir un deuxième courant (Iptat) proportionnel à la température absolue ;
   un deuxième élément résistif (R) comprenant un ou plusieurs transistors MOS (T) en série et montés chacun en diode, le deuxième élément résistif (R) ayant une première borne connectée à un noeud (502) d'application d'un potentiel de référence (GND) et une deuxième borne couplée à un noeud (504) d'application d'un potentiel d'alimentation (VDD) ;
   un deuxième circuit (C1) connecté au premier circuit (BG) et configuré pour fournir une première copie (Ibgc1) du premier courant (Ibg) et que ladite première copie circule dans le deuxième élément résistif (R), le deuxième élément résistif (R) faisant partie du deuxième circuit (C1) ; et
   un troisième circuit (C2) connecté au premier circuit (BG) et configuré pour :

- fournir une copie (Iptatc1) du deuxième courant (Iptat), fournir une première tension de commande (V1) à partir de ladite copie du deuxième courant, et appliquer la première tension de commande à une grille arrière (600) des transistors (T) de l'élément résistif, ou

- fournir une deuxième copie (Ibgc3 ; Ibgc2) du premier courant (Ibg) et une copie (Iptatc1 ; Iptatc2) du deuxième courant (Iptat), fournir une première tension de commande (V1) à partir d'une différence (Idiff) entre la deuxième copie du deuxième courant et la copie du premier courant, et appliquer la première tension de commande à une grille arrière (600) des transistors (T) du deuxième élément résistif.

2. Dispositif selon la revendication 1, dans lequel la deuxième borne du deuxième élément résistif (R) est configurée pour fournir une tension de polarisation (Vbias1) à une capacité variable (Cvar).

3. Dispositif selon la revendication 2, dans lequel :

le dispositif (500) comprend la capacité variable (Cvar) ;
la capacité variable (Cvar) est configurée pour recevoir une tension de réglage (Vtune) et la tension de polarisation (Vbias1) ; et
une différence entre la tension de réglage et la tension de polarisation détermine une valeur de la capacité.

4. Dispositif selon la revendication 1, dans lequel :

le deuxième élément résistif (R) est en série avec une résistance (R51) ;
la deuxième borne du deuxième élément résistif (R) est configurée pour fournir une première tension de polarisation (Vbias1) à une capacité variable (Cvar) et est connectée à une première borne de ladite résistance (R51) ; et
une deuxième borne de ladite résistance (R51) est configurée pour fournir une deuxième tension de polarisation (Vbias2) à la capacité variable.

5. Dispositif selon la revendication 4, dans lequel :

le dispositif (500) comprend la capacité variable (Cvar) ;
la capacité variable (Cvar) est configurée pour recevoir une tension de réglage (Vtune) et les première et deuxième tensions de polarisation (Vbias1, Vbias2) ; et

une différence entre la tension de réglage et la première tension de polarisation et une différence entre la tension de réglage et la deuxième tension de polarisation déterminent une valeur de la capacité.

6. Dispositif selon la revendication 3 ou 5, dans lequel le dispositif (500) comprend un oscillateur commandé en tension (VCO) comprenant la capacité variable (Cvar).

7. Dispositif selon la revendication 6, dans lequel le dispositif (500) comprend un circuit de fourniture de la tension de réglage (Vtune), ledit circuit comprenant, par exemple, une boucle à verrouillage de phase.

8. Dispositif selon l'une quelconque des revendications 1 à 7, dans lequel le troisième circuit (C2) comprend une résistance (R52) ayant une première borne connectée au noeud (502) d'application du potentiel de référence (GND) ou au noeud (504) d'application du potentiel d'alimentation (VDD), une deuxième borne (600) de ladite résistance (R52) étant configurée pour fournir la première tension de commande (V1) et étant connectée à la grille arrière (600) des transistors (T) du deuxième élément résistif (R).

9. Dispositif selon la revendication 8, dans lequel le troisième circuit (C2) comprend une capacité de lissage (Cf) connecté entre la grille arrière (600) des transistors (T) du deuxième élément résistif (R) et le noeud (502) d'application du potentiel de référence (GND).

10. Dispositif selon l'une quelconque des revendications 1 à 9, dans lequel les transistors (T) du deuxième élément résistif (R) sont tous des transistors à canal N ou sont tous des transistors MOS à canal P.

11. Dispositif selon l'une quelconque des revendications 1 à 10, dans lequel les transistors (T) du deuxième élément résistif (R) sont tous mis en oeuvre sur silicium sur isolant.

12. Dispositif selon l'une quelconque des revendications 1 à 11, dans lequel le troisième circuit (C2) comprend un circuit de réglage d'une pente de la première tension de commande (V1) avec la température.

13. Dispositif selon la revendication 12 prise dans sa dépendance à la revendication 8, dans lequel le circuit de réglage comprend un ou plusieurs ensembles (K1, K2, K3) comprenant chacun :

- une première résistance (R91, R92, R93) et un premier interrupteur (SW91, SW92, SW93) en série entre le noeud (504) d'application du potentiel d'alimentation (VDD) et la deuxième borne de la résistance (R52) fournissant la première tension de commande (V1), et

- une deuxième résistance (R81, R82, R83) et un deuxième interrupteur (SW81, SW82, SW83) en série entre la deuxième borne de la résistance fournissant la première tension de commande (V1) et le noeud (502) d'application du potentiel de référence (GND), une valeur de la deuxième résistance de l'ensemble étant identique à une valeur de la première résistance de l'ensemble.

**14.** Dispositif selon la revendication 13, dans lequel :

le circuit de réglage comprend plusieurs desdits ensembles (K1, K2, K3) ; et
une valeur de la première résistance (R91, R92, R93) est différente dans chacun desdits ensembles.

**15.** Dispositif selon la revendications 12, dans lequel :

la première tension de commande (V1) est déterminée par la différence entre la deuxième copie (Ibgc3 ; Ibgc2) du premier courant (Ibg) et la copie (Iptatc1 ; Iptatc2) du deuxième courant (Iptat) ;
le circuit de réglage de la pente comprend un quatrième circuit (C3, T7 ; T5) configuré pour fournir la deuxième copie du premier courant (Ibg), et un cinquième circuit (T2 ; C3, T7) configuré pour fournir la deuxième copie du deuxième courant (Iptat), un gain du quatrième circuit et
un gain du cinquième circuit étant réglables de sorte à permettre le réglage de la pente de la première tension de commande (V1) avec température.

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

Europäisches
Patentamt

European
Patent Office

Office européen
des brevets

**RAPPORT DE RECHERCHE EUROPEENNE**

Numéro de la demande

EP 25 15 6421

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2007/040543 A1 (YEO KOK-SOON [SG] ET AL) 22 février 2007 (2007-02-22) * figure 3 * ----- | 1-15 | INV.<br>H03B5/04<br>G05F3/30<br>H03B5/12 |
| A | US 2021/349491 A1 (RAMORINI STEFANO [IT] ET AL) 11 novembre 2021 (2021-11-11) * figure 3 * ----- | 1-15 | H03J3/20<br>H03L1/02<br>G05F3/20 |
| A | US 2019/317543 A1 (YOSHIDA HARUHIKO [JP]) 17 octobre 2019 (2019-10-17) * figure 3 * ----- | 1-15 | |
| A | US 2018/269830 A1 (HOSHINO HIROAKI [JP]) 20 septembre 2018 (2018-09-20) * alinéa [0079]; figures 10, 11 * ----- | 1-15 | |

**DOMAINES TECHNIQUES RECHERCHES (IPC)**

H03B
H03J
H03L
G05F

Le présent rapport a été établi pour toutes les revendications

| Lieu de la recherche | Date d'achèvement de la recherche | Examinateur |
|---|---|---|
| Munich | 3 juillet 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 15 6421

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-07-2025

| Document brevet cité au rapport de recherche | Date de publication | Membre(s) de la famille de brevet(s) | | Date de publication |
|---|---|---|---|---|
| US 2007040543 A1 | 22-02-2007 | CN | 1940800 A | 04-04-2007 |
| | | GB | 2429307 A | 21-02-2007 |
| | | JP | 2007052789 A | 01-03-2007 |
| | | US | 2007040543 A1 | 22-02-2007 |
| US 2021349491 A1 | 11-11-2021 | CN | 112882524 A | 01-06-2021 |
| | | CN | 214756284 U | 16-11-2021 |
| | | EP | 3828662 A1 | 02-06-2021 |
| | | IT | 201900022518 A1 | 29-05-2021 |
| | | US | 2021165438 A1 | 03-06-2021 |
| | | US | 2021349491 A1 | 11-11-2021 |
| US 2019317543 A1 | 17-10-2019 | CN | 110192164 A | 30-08-2019 |
| | | DE | 112017006858 T5 | 26-09-2019 |
| | | JP | 6873827 B2 | 19-05-2021 |
| | | JP | 2018116673 A | 26-07-2018 |
| | | US | 2019317543 A1 | 17-10-2019 |
| US 2018269830 A1 | 20-09-2018 | JP | 6656195 B2 | 04-03-2020 |
| | | JP | 2018152811 A | 27-09-2018 |
| | | US | 2018269830 A1 | 20-09-2018 |

EPO FORM P0460

Pour tout renseignement concernant cette annexe : voir Journal Officiel de l'Office européen des brevets, No.12/82